# EUROPEAN PATENT APPLICATION

(11) **EP 4 618 130 A1**
(43) Date of publication of application: **17.09.2025**
(21) Application number: 23887570.2
(22) Date of filing: 17.08.2023
(51) Int. Cl.: H01J 37/08, H01J 27/18

(54) **ION SOURCE DEVICE, ION SOURCE SYSTEM AND DEBUGGING METHOD THEREFOR**

(30) Priority: 11.11.2022 CN 202211413448
(71) Applicant: Jiangsu Leuven Instruments Co. Ltd, Xuzhou, Jiangsu 221300 (CN)
(72) Inventor: HU, Dongdong, Xuzhou, Jiangsu 221300 (CN); YANG, Zhen, Xuzhou, Jiangsu 221300 (CN); YAN, Kuicheng, Xuzhou, Jiangsu 221300 (CN); CHEN, Longbao, Xuzhou, Jiangsu 221300 (CN); LIU, Haiyang, Xuzhou, Jiangsu 221300 (CN); GUO, Song, Xuzhou, Jiangsu 221300 (CN); XU, Kangning, Xuzhou, Jiangsu 221300 (CN); XU, Kaidong, Xuzhou, Jiangsu 221300 (CN)
(74) Representative: Eisenführ Speiser
(86) International application number: PCT/CN2023/113469
(87) International publication number: WO 2024/098875

(57) **Abstract**

An ion source device, an ion source system and a debugging method therefor. The ion source device comprises a working barrel, a gas inlet pipe, and an excitation coil. The working barrel comprises a top plate and an annular side plate; the top plate and the annular side plate define a discharge chamber; the end of the annular side plate away from the top plate defines an outlet; and the excitation coil is sleeved on the annular side plate. The ion source device further comprises a first magnet and a second magnet; the first magnet is located on the side of the top plate facing away from the discharge chamber; the second magnet is located on the side of the annular side plate facing away from the discharge chamber; the second magnet is located on the side of the excitation coil close to the outlet; the field strength of the first magnet is greater than that of the second magnet; and the first magnet and the second magnet form a guide magnetic field in the discharge chamber. A guide magnetic field can be formed in the ion source device, so that the motion of plasmas can be restrained, thereby reducing the loss of the plasmas.

## Description

The present application claims the priority to Chinese Patent Application No. 202211413448.7, titled "ION SOURCE DEVICE, ION SOURCE SYSTEM AND DEBUGGING METHOD THEREFOR", filed with the China National Intellectual Property Administration on November 11, 2022, the entire content of which is incorporated herein by reference.

### FIELD

The present application relates to the technical field of ion sources, and in particular, to an ion source device, an ion source system and a debugging method therefor.

### BACKGROUND

An ion Beam Etching (IBE) system is increasingly used in the current manufacturing process of semiconductor devices, sensor devices, and memory devices, etc.. The operating principle of IBE is that under a low pressure, gas is introduced into an ion source device and is excited to generate plasma, and an ion beam is then extracted and accelerated through an ion source grid. Electrons generated by a neutralizer neutralize the ions in the ion beam, and the particle beam can reach the surface of the component to be processed, thereby achieving the purpose of etching.

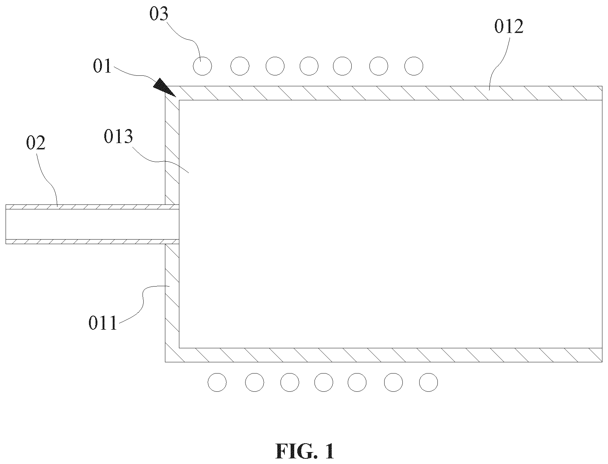

Referring to FIG. 1, FIG. 1 is a schematic structural view of an ion source device in the prior art.

As shown in FIG. 1, a common ion source device includes a working barrel 01 and a gas inlet pipe 02. The working barrel 01 includes a top plate 011 and an annular side plate 012, and the top plate 011 and the annular side plate 012 may enclose and form a discharge chamber 013. The gas inlet pipe 02 is mounted on the top plate 011 for introducing a working gas into the discharge chamber 013, and an excitation coil 03 is arranged on an outer side of the working barrel 01. By applying radio frequency power to the excitation coil 03, inductively coupled plasma (ICP) may be generated from the working gas within the discharge chamber 013.

Under a low-voltage condition, the motion of ICP is mainly diffusion, and both the top plate 011 and the annular side plate 012 will be bombarded due to free diffusion movement of the ICP, which in turn affects the service life of the working barrel 01. Moreover, the ICP bombarding onto the top plate 011 and the annular side plate 012 may be lost in the process, resulting in a significant reduction in the number of ICP ultimately obtained.

Therefore, how to provide a solution to overcome or reduce the above defects is still a technical challenge that needs to be solved urgently by those skilled in the art.

### SUMMARY

In view of this, an object of the present application is to provide an ion source device, an ion source system and a debugging method therefor, and a first magnet and a second magnet in the ion source device can form a guiding magnetic field, which can restrain the movement of the plasma, so that the loss of the plasma can be reduced.

In order to solve the above technical problem, the present application provides an ion source device, including a working barrel, a gas inlet pipe and an excitation coil. The working barrel includes a top plate and an annular side plate; the top plate and the annular side plate enclose and form a discharge chamber; one end of the annular side plate far away from the top plate defines an outlet, and the excitation coil is mounted outside the annular side plate. The ion source device further includes a first magnet and a second magnet; the first magnet is located at one side of the top plate facing away from the discharge chamber; the second magnet is located at one side of the annular side plate facing away from the discharge chamber; the second magnet is located at one side of the excitation coil close to the outlet; the first magnet has a field strength greater than that of the second magnet, and the first magnet and the second magnet form a guiding magnetic field in the discharge chamber.

In this solution, the guiding magnetic field formed by the first magnet and the second magnet may restrict the movement of the plasma, thereby changing the original free diffusion state of the plasma. Moreover, since the field strength of the first magnet is greater than that of the second magnet, the field strength of the guiding magnetic field is relatively high at the position close to the top plate in the axial direction, while the field strength of the guiding magnetic field is relatively low at the position relatively far away from the top plate in the axial direction. The distribution of field strength of the magnetic field within the discharge chamber exhibits an obvious "magnetic mirror effect", which can force the plasma to move towards a region where the magnetic field is weakened. Specifically, the plasma is forced to move towards the side where the outlet is located, so that the sputtering of the plasma onto the top plate can be reduced. Additionally, the restriction of the guiding magnetic field on the plasma movement inherently can minimize the outward diffusion of the plasma in the radial direction, and can also reduce the sputtering of the plasma onto the annular side plate. As a result, damage to the working barrel can be reduced, which is beneficial for prolonging the service life of the working barrel and reducing the loss of the plasma.

In an embodiment, the first magnet and the second magnet are both annular, the first magnet is mounted outside the gas inlet pipe, and the second magnet is mounted outside the annular side plate.

In an embodiment, the first magnet includes multiple first segments, which are distributed around the gas inlet pipe and spaced apart from each other. The second magnet includes multiple second segments, which are distributed around the gas inlet pipe and spaced apart from each other.

In an embodiment, the first magnet has a first N-pole and a first S-pole, and an arrangement direction of the first N-pole and the first S-pole is parallel to an axial direction of the working barrel.

In an embodiment, the second magnet has a second N-pole and a second S-pole, and an arrangement direction of the second N-pole and the second S-pole is parallel to an axial direction of the working barrel.

In an embodiment, the second magnet has a second N-pole and a second S-pole, and a distribution direction of the second N-pole and the second S-pole forms an angle with an axial direction of the working barrel.

In an embodiment, the ion source device further includes a first driving component, which is connected to the first magnet for driving the first magnet to move.

In an embodiment, a movement direction of the first magnet is parallel to the axial direction of the working barrel.

In an embodiment, the ion source device further includes a second driving component, which is connected to the second magnet for driving the second magnet to move.

In an embodiment, a movement direction of the second magnet is parallel to the axial direction of the working barrel.

In an embodiment, the gas inlet pipe and the working barrel are coaxially arranged.

The present application further provides an ion source system, including the above ion source device.

Since the above ion source device has the above technical effects, the ion source system including the ion source device also has similar technical effects, which will not be repeated here.

In an embodiment, the ion source system further includes an ion source grid, which is located on one side of the outlet far away from the top plate.

In an embodiment, there are two ion source grids, which are distributed in the axial direction of the working barrel, and each of the two ion source grids is equipped with a power supply.

In an embodiment, the ion source system further includes a controller, a radio frequency power supply, a matching box and a neutralizer. Both the radio frequency power supply and the neutralizer are in signal connection with the controller, the radio frequency power supply is electrically connected to the matching box, which is electrically connected to the excitation coil. The controller is configured to control a gas inlet parameter of the gas inlet pipe.

In an embodiment, the ion source device further includes a first driving component and a second driving component. The first driving component is connected to the first magnet for driving the first magnet to move, the second driving component is connected to the second magnet for driving the second magnet to move, and the controller is in signal connection with the first driving component and the second driving component respectively.

The present application further provides a debugging method for an ion source system, and this debugging method is applicable to the ion source system. The ion source system includes the ion source grid, which is located on one side of the outlet far away from the top plate. The ion source device further includes the first driving component and the second driving component, and the first driving component is connected to the first magnet, and the second driving component is connected to the second magnet. The debugging method includes the following steps: a control step, an acquisition step, a determination step, an adjustment step and a storage step. In the control step, the ion source system is controlled to operate at a set operation parameter. In the acquisition step, a characteristic parameter of the ion source grid is acquired. In the determination step, it is determined whether the characteristic parameter reaches a preset parameter, if not, the following adjustment step is repeatedly performed, and if yes, the following storage step is performed. In the adjustment step, the position of the first magnet is adjusted by the first driving component, and/or the position of the second magnet is adjusted by the second driving component, and the determination step is repeatedly performed. In the storage step, position information of the first magnet and position information of the second magnet are stored, and the position information corresponds to the set operation parameter.

Through the above debugging method, the optimal position information corresponding to the operation parameter can be obtained and set, so as to better meet subsequent operation requirements.

In an embodiment, the ion source system includes a radio frequency power supply, and the set operation parameter includes at least one of a power parameter of the radio frequency power supply and a gas inlet parameter of the gas inlet pipe.

In an embodiment, the characteristic parameter includes at least one of a voltage parameter, a current parameter and a plasma quantity parameter of the ion source grid.

In an embodiment, there are multiple groups of the set operation parameters.

### BRIEF DESCRIPTION OF THE DRAWINGS

FIG. 1 is a schematic structural view of an ion source device in the prior art;
FIG. 2 is a schematic structural view of an ion source device according to a specific embodiment of the present application;
FIG. 3 is a schematic structural view of a variation of FIG. 2;
FIG. 4 is a schematic structural view of a first magnet;
FIG. 5 is a schematic structural view of a second magnet;
FIG. 6 is a schematic structural view of an ion source system according to a specific embodiment of the present application;
FIG. 7 is a schematic flowchart of a debugging method for the ion source system according to the present application.

Reference numerals in FIG. 1 are explained as follows:

| | | | | | |
|---|---|---|---|---|---|
| 01. | working barrel; | 011. | top plate; | 012. | annular side plate; |
| 013. | discharge chamber; | 02. | gas inlet pipe; | 03. | excitation coil. |

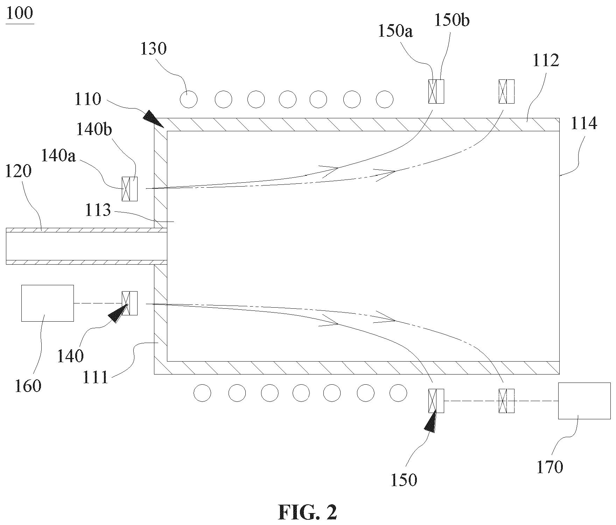

The reference numerals in FIG. 2 to FIG. 7 are illustrated as follows:

| | | | | | |
|---|---|---|---|---|---|
| 100. | ion source device; | 110. | working barrel; | 111. | top plate; |
| 112. | annular side plate; | 113. | discharge chamber; | 114. | outlet; |
| 120. | gas inlet pipe; | 130. | excitation coil; | 140. | first magnet; |
| 141. | first segment; | 140a. | first N-pole; | 140b. | first S-pole; |
| 150. | second magnet; | 151. | second segment; | 150a. | second N-pole; |
| 150b. | second S-pole; | 160. | first driving component ; | | |
| 170. | second driving component; | 200. | ion source grid; | 210. | first grid; |
| 220. | second grid; | 230. | first power supply; | 240. | second power supply; |
| 300. | controller; | 400. | radio frequency power supply; | | |
| 500. | matching box; | 600. | neutralizer; | A. | to-be-processed component. |

### DETAILED DESCRIPTION OF THE EMBODIMENTS

In order to enable those skilled in the art to better understand the technical solutions of the present application, the present application will be described in further detail below in conjunction with the accompanying drawings and specific embodiments.

In the description of the embodiments of the present application, the terms "first" and "second" are used for descriptive purposes only, and should not be understood as indicating or implying relative importance or implicitly indicating the number of indicated technical features. Therefore, a feature defined by "first" or "second" may explicitly or implicitly include one or more of the features.

In the description of the embodiments of the present application, it should be noted that unless stated or defined specifically, the terms "mount", "link", and "connect" should be understood in a broad sense, for example, the term "connect" may refer to a detachable connection or a non-detachable connection; or a direct connection, or an indirect connection through an intermediate medium.

In the description of the embodiments of the present application, the orientation or positional relationships indicated by the terms such as "inner", "outer" and the like are used based on the orientation or positional relationships shown in the accompanying drawings, so they are only used to facilitate the better and clearer description of the present application, rather than indicating or implying that the devices or elements referred to must have a specific orientation or can only be configured and operated in a particular orientation. Therefore, the above-mentioned terms should not be construed as limitations to the present application.

In the description of the embodiments of the present application, the term "multiple" refers to a plural indefinite number or quantity, usually two or more. When the term "multiple" is used to indicate the number of certain components, it does not indicate that these components are quantitatively related to each other.

In the description of the embodiments of the present application, the terms "include", "comprise", or any other variant thereof are intended to cover non-exclusive inclusion, so that a process, method, article, or device including a series of elements includes not only those elements, but also other elements that are not explicitly listed, or elements inherent to the process, method, article, or device. Unless expressively limited otherwise, the element defined by the statement "comprising (including) a..." does not exclude the case that other similar elements may exist in the process, method, article or device including the element.

In the embodiments of the present application, the term "and/or" is merely used to describe an association relationship between associated objects, indicating that three relationships may exist, for example, the expression "A and/or B" may indicate that A exists alone, A and B exist at the same time, and B exists alone. In addition, the character "/" in the present application generally indicates an "or" relationship between the associated objects before and after the character "/".

### First Embodiment

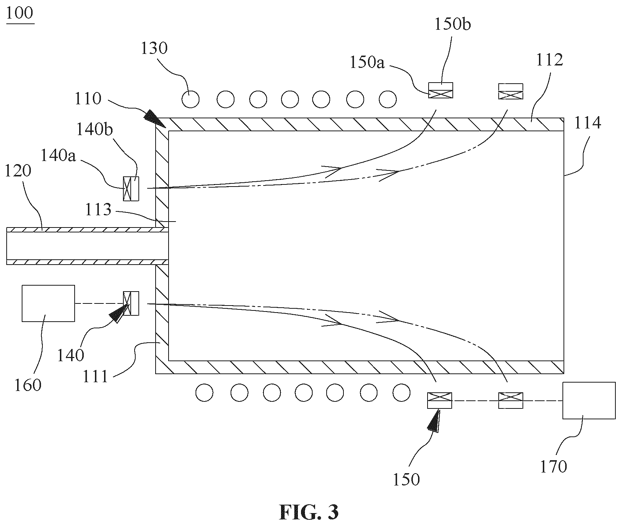

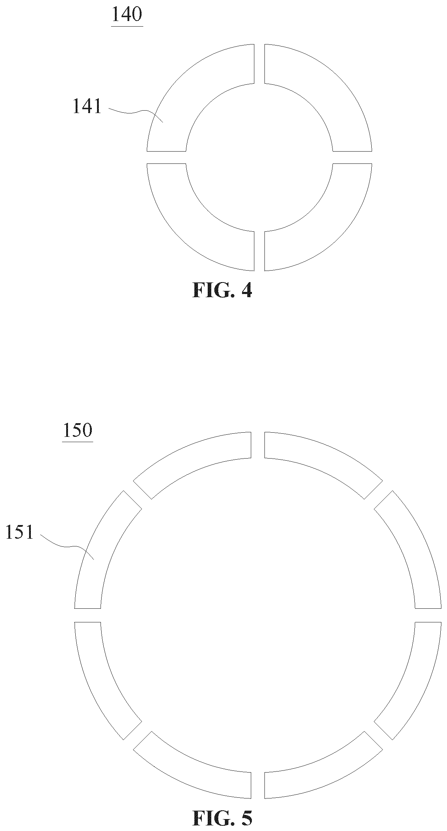

Referring to FIG. 2 to FIG. 5, FIG. 2 is a schematic structural view of an ion source device according to a specific embodiment of the present application, FIG. 3 is a schematic structural view of a variation of FIG. 2, FIG. 4 is a schematic structural view of a first magnet, and FIG. 5 is a schematic structural view of a second magnet.

As shown in FIG. 2, the present application provides an ion source device 100, including a working barrel 110, a gas inlet pipe 120, and an excitation coil 130.

The working barrel 110 includes a top plate 111 and an annular side plate 112, and the annular side plate 112 may be mounted on one side of the top plate 111 (a right side in FIG. 2). The specific installation manner may include but not be limited to welding, screwing, clipping, bonding, riveting, etc.. After the assembly is completed, the top plate 111 and the annular side plate 112 may enclose and form a discharge chamber 113, and one end of the annular side plate 112 far away from the top plate 111 define an outlet 114.

The gas inlet pipe 120 may be mounted in the top plate 111, and an internal channel of the gas inlet pipe 120 may be in communication with the discharge chamber 113 for introducing a working gas into the discharge chamber 113. During specific installation, the gas inlet pipe 120 may be coaxially arranged with the working barrel 110, so as to ensure the axial symmetry of plasma distribution within the discharge chamber 113. It should be understood that the coaxial herein means generally coaxial, which allows a certain assembly error and the like.

In addition, in practical applications, the eccentric arrangement of the gas inlet pipe 120 and the working barrel 110 is also allowed. The specific arrangement needs to be determined based on the requirements of a subsequent process (such as an etching process) and the like.

When the excitation coil 130 is mounted outside the annular side plate 112. When radio frequency power is applied to the excitation coil 130, the working gas within the discharge chamber 113 may generate inductively coupled plasma. As described in the background, the motion of plasma in the discharge chamber 113 is mainly freely diffusion, so that a considerable amount of plasma will collide with the top plate 111 and an inner wall surface of the annular side plate 112. In this way, on one hand, the service life of the working barrel 110 is affected; and on the other hand, a large amount of plasma can be lost.

Thus, in this embodiment of the present application, the ion source device 100 further includes a first magnet 140 and a second magnet 150. As shown in FIG. 2, the first magnet 140 is located on one side of the top plate 111 facing away from the discharge chamber 113, that is, the first magnet 140 is located on an outer side of the working barrel 110 in an axial direction. The second magnet 150 is located on one side of the annular side plate 112 facing away from the discharge chamber 113, that is, the second magnet 150 is located on an outer side of the working barrel 110 in a radial direction, and the second magnet 150 is located on a side of the excitation coil 130 close to the outlet 114; the first magnet 140 has a field strength greater than that of the second magnet 150, and the first magnet 140 and the second magnet 150 form a guiding magnetic field within the discharge chamber 113.

In this solution, the guiding magnetic field formed by the first magnet 140 and the second magnet 150 may restrict the movement of the plasma, thereby changing the original free diffusion state of the plasma. Moreover, since the field strength of the first magnet 140 is greater than that of the second magnet 150, the field strength of the guiding magnetic field is relatively high at the position close to the top plate 111 in the axial direction, while the field strength of the guiding magnetic field is relatively low at the position relatively far away from the top plate 111 in the axial direction. The distribution of field strength of the magnetic field within the discharge chamber 113 exhibits an obvious "magnetic mirror effect", which can force the plasma to move towards a region where the magnetic field is weakened. Specifically, the plasma is forced to move towards the side where the outlet 114 is located, so that the sputtering of the plasma onto the top plate 111 can be reduced. Additionally, the restriction of the guiding magnetic field on the plasma movement inherently can minimize the outward diffusion of the plasma in the radial direction, and can also reduce the sputtering of the plasma onto the annular side plate 112. As a result, damage to the working barrel 110 can be reduced, which is beneficial for prolonging the service life of the working barrel 110 and reducing the loss of the plasma.

Herein, the specific structural forms of the first magnet 140 and the second magnet 150 are not limited in this embodiment of the present application. In practical applications, those skilled in the art may set them based on actual needs, as long as they can meet the use requirements.

In a specific solution, the first magnet 140 and the second magnet 150 may both be annular, the first magnet 140 may be mounted outside the gas inlet pipe 120, and the second magnet 150 may be mounted outside the annular side plate 112. In this way, the guiding magnetic field is an annular magnetic field. With reference to FIG. 2, the guiding magnetic field within the discharge chamber 113 is substantially flared, and the plasma may swirl around the magnetic field, so that the distribution uniformity of the plasma in the discharge chamber 113 may be greatly improved.

The excitation coil 130 may generate a vortex-induced electric field, which may form eddy currents in the first magnet 140/the second magnet 150. This causes an increase in heat generation of the first magnet 140/ second magnet 150, which in turn will cause an increase in loss and affect the service life of the first magnet 140/ second magnet 150.

In view of this, in this embodiment of the present application, each of the first magnet 140 and the second magnet 150 may be designed in a segmented manner. As shown in FIG. 4, the first magnet 140 may include multiple first segments 141, which are distributed around the gas inlet pipe 120 and spaced apart from each other. As shown in FIG. 5, the second magnet 150 may include multiple second segments 151, which are distributed around the annular side plate 112 and spaced apart from each other. This configuration is intended to mitigate the impact of the vortex-induced electric field on the first magnet 140/the second magnet 150, thereby prolonging the service life of the first magnet 140/the second magnet 150.

Here, the number of the first segments 141 and the number of the second segments 151 are not limited in this embodiment of the present application, and in practical applications, those skilled in the art may design based on specific requirements, as long as the use requirements can be met. In the solution of FIG. 4, there may be four first segments 141; and in the solution of FIG. 5, there may be eight second segments 151.

Still referring to FIG. 2, the first magnet 140 may have a first N-pole 140a and a first S-pole 140b opposite to each other, and a distribution direction of the first N-pole 140a and the first S-pole 140b may be parallel to the axial direction of the working barrel 110. The second magnet 150 may also have a second N-pole 150a and a second S-pole 150b opposite to each other, and a distribution direction of the second N-pole 150a and the second S-pole 150b may be parallel to the axial direction of the working barrel 110. Moreover, the polarity of the magnetic pole of the second magnet 150 on one side facing the annular side plate 112 and the polarity of the magnetic pole of the first magnet 140 on one side facing the top plate 111 may be opposite, so as to form the above guiding magnetic field in the discharge chamber 113.

It should be understood that the distribution direction of the first magnet 140 and the second magnet 150 in the above solution is merely an exemplary description of the embodiment of the present application, and cannot be used as a limitation to the implementation scope of the ion source device 100 in the present application. Other distribution of the first magnet 140 and the second magnet 150 can also be adopted, as long as the guiding magnetic field can be formed. For example, the distribution direction of the first N-pole 140a and the first S-pole 140b may form an angle with the axial direction of the working barrel 110; and/or, the arrangement direction of the second N-pole 150a and the second S-pole 150b may form an angle with the axial direction of the working barrel 110. For example, as shown in FIG. 3, the arrangement direction of the second N-pole 150a and the second S-pole 150b may form a ninety-degree angle with the axial direction of the working barrel 110, and the magnetic circuit formed in this solution may be deeper.

In some alternative embodiments, the ion source device 100 provided in the present application may further include a first driving component 160, which may be connected to the first magnet 140 and is configured to drive the first magnet 140 to move, so that a position of the first magnet 140 relative to the working barrel 110 can be adjusted, thereby changing a topological structure of the guiding magnetic field in the discharge chamber 113.

Here, this embodiment of the present application does not limit the movement direction of the first magnet 140, and correspondingly, this embodiment of the present application also does not limit the structural form of the first driving component 160, as long as the use requirements can be met.

In one solution, the first magnet 140 may be moved in a linear direction, for example, may be moved in the axial direction of the working barrel 110; alternatively, the first magnet 140 may be moved in a direction perpendicular to the axial direction of the working barrel 110. In this case, the first driving component 160 may be a linear driving component, for example, a driving element that can directly output a linear movement, such as a linear gas cylinder, a linear oil cylinder, etc. Of course, the first driving component 160 may also be a driving element that can directly output rotational movement, such as a motor, a rotary cylinder, etc. At this time, it is feasible to equip a movement conversion mechanism in the form of a rack-and-pinion mechanism, a lead screw mechanism, etc., so as to convert the rotational movement directly output by the first driving component 160 into the required linear movement.

In another solution, the first magnet 140 may be rotationally moved around a particular axis, for example, the particular axis may be perpendicular to the axial direction of the working barrel 110. In this case, the first driving component 160 may directly adopt a driving element that can output rotational movement, such as a motor, a rotary cylinder, etc..

The first driving component 160 may be directly connected to the first magnet 140; or alternatively, a speed-changing component may be provided to adjust the movement speed of the first magnet 140.

For the foregoing solution in which the first magnet 140 includes multiple first segments 141. If various first segments 141 are operated synchronously, an adapter component may be configured, which may be connected to the first segments 141. The first driving component 160 may be connected to the adapter component to drive the first segments 141 to operate synchronously. Alternatively, multiple first driving components 160 may be set, and the first driving components 160 are respectively connected to the corresponding first segments 141, so as to respectively drive the first segments 141 to operate synchronously. If the first segments 141 are separately operated, multiple first driving components 160 may be set, and the first driving components 160 are respectively connected to corresponding first segments 141, so as to respectively drive the first segments 141.

In some alternative embodiments, the ion source device 100 provided in the present application may further include a second driving component 170, which may be connected to the second magnet 150 to drive the second magnet 150 to move, so that a position of the second magnet 150 relative to the working barrel 110 can be adjusted, thereby changing the topological structure of the guiding magnetic field in the discharge chamber 113.

The movement direction of the second magnet 150 and the structural form of the second driving component 170 are not limited, and reference may be made to the above description about the movement direction of the first magnet 140 and the specific structural form of the first driving component 160.

### Second Embodiment

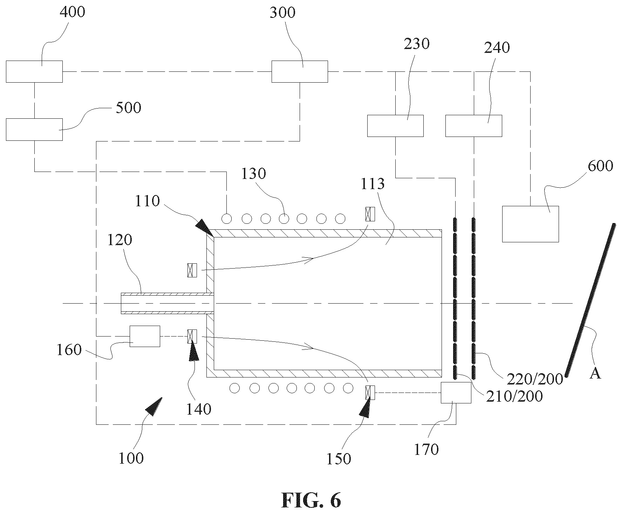

Referring to FIG. 6, FIG.6 is a schematic structural view of an ion source system according to a specific embodiment of the present application.

As shown in FIG. 6, the present application further provides an ion source system, including an ion source device 100, which is the ion source device involved in each implementation of the first embodiment.

Since the ion source device 100 in the first embodiment has the above technical effects, the ion source system including the ion source device 100 also has similar technical effects, which will not be repeated here.

Further, the ion source system may further include an ion source grid 200, which may be located on one side of the outlet 114 far away from the top plate 111 and is configured for extracting and accelerating the plasma.

There may be two ion source grids 200. For ease of description, the two ion source grids 200 may be named as a first grid 210 and a second grid 220 respectively. With reference to FIG. 6, the first grid 210 may be equipped with a first power supply 230, the second grid 220 may be equipped with a second power supply 240, and the first power supply 230 and the second power supply 240 may be independent of each other.

Moreover, the ion source system may further include a controller 300, a radio frequency power supply 400, a matching box 500 and a neutralizer 600. Both the radio frequency power supply 400 and the neutralizer 600 may be in signal connection with the controller 300, the radio frequency power supply 400 may be electrically connected to the matching box 500, which may be electrically connected to the excitation coil 130.

The controller 300 can control a power parameter of the radio frequency power supply 400, and the controller 300 is further used to control a gas inlet parameter of the gas inlet pipe 120, so that the ion source system may set operation parameters for operation. After the plasma generated in the working barrel 110 are extracted and accelerated by the ion source grid 200, the plasma may be neutralized with electrons generated by the neutralizer 600, and finally the obtained particle beam may bombard a surface of a to-be-processed component A for etching. The to-be-processed component A may be a wafer or the like.

The controller 300 may also be in signal connection with the first driving component 160 and the second driving component 170 for respectively controlling the activation and deactivation of the first driving component 160 and the second driving component 170, so as to control the installation position of the first magnet 140 and the installation position of the second magnet 150, in order to change the topological structure of the guiding magnetic field in the discharge chamber 113.

### Third Embodiment

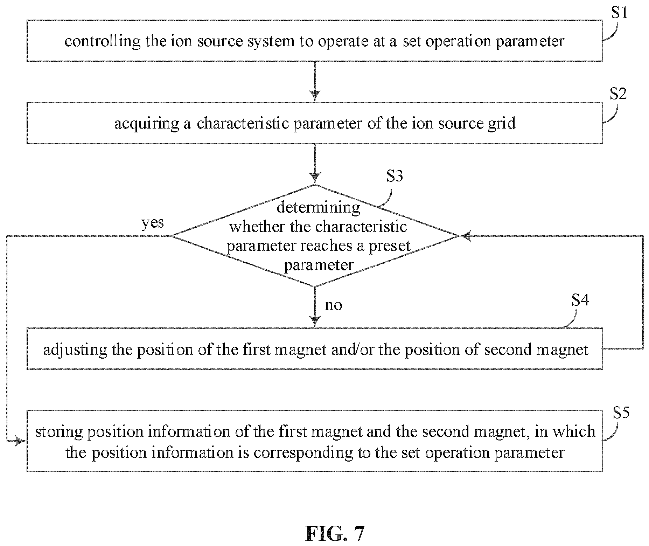

Referring to FIG. 7, FIG. 7 is a schematic flowchart of a debugging method for the ion source system according to the present application.

The present application further provides a debugging method for an ion source system, which is suitable for the ion source system involved in each implementation of the second embodiment. As shown in FIG. 7, the debugging method may include the following steps S1 to S5.

In a control step S1, the ion source system is controlled to operate at a set operation parameter.

The set operation parameter herein may include at least one of a power parameter of the radio frequency power supply 400 and a gas inlet parameter of the gas inlet pipe 120.

In an acquisition step S2, a characteristic parameter of the ion source grid 200 is acquired.

The characteristic parameter herein includes at least one of a voltage parameter, a current parameter, and a plasma quantity parameter of the ion source grid 200. The plasma quantity parameter refers to the quantity of the plasma captured by the ion source grid 200.

In a determination step S3, it is determined whether the characteristic parameter reaches a preset parameter, and if not, adjustment step S4 is performed; if yes, the following storage step S5 is performed.

The preset parameter herein is a preset value, and the specific value of the preset parameter is not limited here. In practical application, those skilled in the art may determine the preset parameter based on specific needs.

In the adjustment step S4, the position of the first magnet 140 is adjusted by the first driving component 160, and/or the position of the second magnet 150 is adjusted by the second driving component 170, so as to change the topological structure of the guiding magnetic field in the discharge chamber 113, and then the foregoing determination step S3 is repeatedly performed.

In the storage step S5, position information of the first magnet 140 and position information of the second magnet 150 are stored, and the position information corresponds to the set operation parameter, so as to be used in subsequent actual operations.

In practice, there may be multiple groups of the set operation parameters, and accordingly, the above debugging method may be executed for many times, so as to obtain the position information of the first magnet 140 and the position information of the second magnet 150 under different set operation parameters, in order to better guide subsequent operations.

Merely some preferred embodiments of the present application are described above. It should be noted that, several improvements and modifications may be made by those skilled in the art without departing from the principle of the present application, and these improvements and modifications should also fall within the protection scope of the present application.

## Claims

1. An ion source device, comprising a working barrel (110), a gas inlet pipe (120) and an excitation coil (130), wherein the working barrel (110) comprises a top plate (111) and an annular side plate (112), the top plate (111) and the annular side plate (112) enclose and form a discharge chamber (113), and one end of the annular side plate (112) far away from the top plate (111) defines an outlet (114); the excitation coil (130) is mounted outside the annular side plate (112);
wherein the ion source device further comprises a first magnet (140) and a second magnet (150), the first magnet (140) is located on one side of the top plate (111) facing away from the discharge chamber (113), the second magnet (150) is located on one side of the annular side plate (112) facing away from the discharge chamber (113), and the second magnet (150) is located on one side of the excitation coil (130) close to the outlet (114); the first magnet (140) has a field strength greater than that of the second magnet (150), and the first magnet (140) and the second magnet (150) form a guiding magnetic field in the discharge chamber (113).

2. The ion source device according to claim 1, wherein the first magnet (140) and the second magnet (150) are both annular, the first magnet (140) is mounted outside the gas inlet pipe (120), and the second magnet (150) is mounted outside the annular side plate (112).

3. The ion source device according to claim 1, wherein the first magnet (140) comprises a plurality of first segments (141), which are distributed around the gas inlet pipe (120) and spaced apart from each other; and the second magnet (150) comprises a plurality of second segments (151), which are distributed around the annular side plate (112) and spaced apart from each other.

4. The ion source device according to claim 1, wherein the first magnet (140) has a first N-pole (140a) and a first S-pole (140b), and a distribution direction of the first N-pole (140a) and the first S-pole (140b) is parallel to an axial direction of the working barrel (110).

5. The ion source device according to claim 1, wherein the second magnet (150) has a second N-pole (150a) and a second S-pole (150b), and a distribution direction of the second N-pole (150a) and the second S-pole (150b) is parallel to an axial direction of the working barrel (110).

6. The ion source device according to claim 1, wherein the second magnet (150) has a second N-pole (150a) and a second S-pole (150b), and a distribution direction of the second N-pole (150a) and the second S-pole (150b) forms an angle with an axial direction of the working barrel (110).

7. The ion source device according to any one of claims 1 to 6, further comprising a first driving component (160), wherein the first driving component (160) is connected to the first magnet (140) for driving the first magnet (140) to move.

8. The ion source device according to claim 7, wherein a movement direction of the first magnet (140) is parallel to an axial direction of the working barrel (110).

9. The ion source device according to any one of claims 1 to 6, further comprising a second driving component (170), wherein the second driving component (170) is connected to the second magnet (150) for driving the second magnet (150) to move.

10. The ion source device according to claim 9, wherein a movement direction of the second magnet (150) is parallel to an axial direction of the working barrel (110).

11. The ion source device according to any one of claims 1 to 6, wherein the gas inlet pipe (120) and the working barrel (110) are coaxially arranged.

12. An ion source system, comprising the ion source device (100) according to any one of claims 1 to 11.

13. The ion source system according to claim 12, further comprising an ion source grid (200), wherein the ion source grid (200) is located on a side of the outlet (114) far away from the top plate (111).

14. The ion source system according to claim 13, wherein there are two ion source grids (200), which are distributed in the axial direction of the working barrel (110), and each of the two ion source grids (200) is equipped with a power supply.

15. The ion source system according to claims 12 to 14, further comprising a controller (300), a radio frequency power supply (400), a matching box (500) and a neutralizer (600), wherein the radio frequency power supply (400) and the neutralizer (600) are both in signal connection with the controller (300), the radio frequency power supply (400) is electrically connected to the matching box (500), which is electrically connected to the excitation coil (130), and the controller (300) is configured to control a gas inlet parameter of the gas inlet pipe (120).

16. The ion source system according to claim 15, wherein the ion source device (100) further comprises a first driving component (160) and a second driving component (170), the first driving component (160) is connected to the first magnet (140) for driving the first magnet (140) to move, and the second driving component (170) is connected to the second magnet (150) for driving the second magnet (150) to move;
the controller (300) is in signal connection with the first driving component (160) and the second driving component (170) respectively.

17. A debugging method for an ion source system, wherein the debugging method is applicable to the ion source system according to any one of claims 12 to 16, the ion source system comprises an ion source grid (200), which is located on one side of the outlet (114) far away from the top plate (111); the ion source device (100) further comprises a first driving component (160) and a second driving component (170), the first driving component (160) is connected to the first magnet (140), the second driving component (170) is connected to the second magnet (150), and the debugging method comprises:
a control step of controlling the ion source system to operate at a set operation parameter;
an acquisition step of acquiring a characteristic parameter of the ion source grid (200);
a determination step of determining whether the characteristic parameter reaches a preset parameter, and if not, performing the following adjustment step, and if yes, performing following storage step;
an adjustment step of adjusting a position of the first magnet (140) by the first driving component (160), and/or adjusting a position of the second magnet (150) by the second driving component (170), and repeatedly performing the determination step;
a storage step of storing position information of the first magnet (140) and the second magnet (150), in which the position information is corresponding to the set operation parameter.

18. The debugging method for the ion source system according to claim 17, wherein the ion source system comprises a radio frequency power supply (400), and the set operation parameter comprises at least one of a power parameter of the radio frequency power supply (400) and a gas inlet parameter of the gas inlet pipe (120).

19. The debugging method for the ion source system according to claim 17, wherein the characteristic parameter comprises at least one of a voltage parameter, a current parameter, and a plasma quantity parameter of the ion source grid (200).

20. The debugging method for the ion source system according to any one of claims 17 to 19, wherein there are multiple groups of the set operation parameters.
